# EUROPEAN PATENT SPECIFICATION

(11) **EP 1 441 864 B1**
(45) Date of publication and mention of the grant of the patent: **18.11.2009**
(21) Application number: 00903364.8
(22) Date of filing: 21.01.2000
(51) Int. Cl.: B05D 5/12, H01B 1/02, H01L 21/48, H05K 1/09

(54) **METHOD FOR FORMING THIN-FILM CONDUCTORS THROUGH THE DECOMPOSITION OF METAL-CHELATES IN ASSOCIATION WITH METAL PARTICLES**
VERFAHREN ZUR HERSTELLUNG VON DÜNNFILMLEITERN DURCH ZERSETZUNG VON METALLCHELATEN IN VERBINDUNG MIT METALLTEILCHEN
PROCEDE DE FORMATION DE CONDUCTEURS EN COUCHES MINCES PAR DECOMPOSITION DE CHELATES METALLIQUES EN ASSOCIATION A DES PARTICULES METALLIQUES

(43) Date of publication of application: 04.08.2004
(73) Proprietor: Midwest Research Institute, Kansas City Missouri 64110 (US)
(72) Inventor: SCHULZ, Douglas, L., Medford, MA 02155 (US); CURTIS, Calvin, J., Lakewood, CO 80232 (US); GINLEY, David, S., Evergreen, CO 80439 (US)
(74) Representative: Steinecke, Peter
(86) International application number: PCT/US2000/001432
(87) International publication number: WO 2001/053007

(56) References cited:
- US-A- 5 281 635
- US-A- 5 474 800
- US-A- 5 474 800
- US-A- 5 597 614
- US-A- 5 597 614
- US-A- 5 612 087
- US-A- 5 612 087
- US-A- 5 871 840
- US-A- 5 871 840
- US-A- 5 882 722
- US-A- 5 882 722

## Description

### Technical Field.

This invention relates to a process for the preparation of particle-derived electrically conductive thin-films by depositing metal particles and metal chelates, mixed or separately, (e.g., Ni metal and Ni(cyclooctadine)₂) on a substrate and heating the composite sufficient to cause decomposition of the metal-chelate complex and the formation of an electrically conducting film with decomposition products of the metal-chelate complex bonding the nanoparticles

### Background Art.

While various methods for the production of particle-derived thin-films have been reported, the application of these materials in microelectronics has been hampered by a lack of good interparticle connectivity when applied as films to substrates. This connectivity, both structural and electrical, is in many cases limited by the formation of a passivating layer (i.e., oxide or hydroxide) contaminating the surface of the particles. These passivated surfaces generally give rise to an insulating effect electrically and an impedance in particle sintering structurally.

In order to form a thin-film for use in photoconversion and microelectronic device applications, the regions coated with nanoparticles are typically sintered to ensure electrical continuity across the feature. A reduced melting temperature for nanophase metals (C.R.M. Wronski, Brit. J. Appl. Phys., (1967)18:1731; J. F. Pocza, A. Barna and P. B. Barna, J. Phys. F. (1972)2:441) and semiconductors (A. N.Goldstein, C.M. Echer and A. P. Alivisatos, Science, (1992)256:1425; and A. N. Goldstein, Ph. D. dissertation, University of California at Berkley (1993)) has previously been shown. These disclosures are incorporated by reference herein. High temperature sintering often eliminates some of the problems associated with surface contamination. However, particle-based contacts to photovoltaic semiconductors are an example of devices where standard hightemperature sintering cannot be performed due to thermal limitations associated with the underlying layers. For example, the thermal treatment of a Ni contact onto a Zn0 conducting layer, as the top layer in a CuInSe2 ("CIS") solar cell, is limited to ∼200°C for 2 minutes because of the thermal instability of the underlying solar cell device. Moreover, it has been found that when a 1,2-propanediol slurry ofNi powder is deposited onto a conducting Zn0 film and annealed in air at 200°C for 2 minutes, the resultant Ni contact becomes crumbly in structure and is not electrically conductive.

In view of the foregoing considerations, there is an apparent need for a process for the preparation of particle-derived thin-film conductors which are useful in microelectronics, solar conversion technologies, and the like, and characterized by good interparticle structural connectivity and electrical conduction. Accordingly, a primary object of the present invention is to provide a method for forming an electrically conducting particle-derived thin-film on a substrate.

Another object of the present invention is to provide a method for forming a metallic film having electrical conductivity and structural connectivity in CIS solar cells.

It is yet another object of the present invention to provide a method of forming a Ni film having electrical conductivity and structural connectivity to a ZnO layer in CIS solar cells.

These and other objects of the present invention will become apparent throughout the description of the invention which now follows.

### Disclosure of the Invention.

The present invention provides a process for forming thin-films of conductors from particles. The process comprises depositing metal particles and metal-chelates, mixed or separately, on a substrate to form a thin film composite, and treating the composite by photolytic action in such a manner as to cause decomposition of the metal-chelate complex thereby forming an electrically conducting composite film matrix wherein the particles are bonded by the decomposition products of the metal-chelates. According to an embodiment not being subject-matter of the present invention mixtures of metallic particles and metal-chelates can be applied onto a substrate heated by a susceptor having a relatively high temperature such that the temperature is high enough to evaporate the solvent and cause thermal decomposition of the metal complex. Alternatively, according to the present invention the particle/metal chelate mixture can be applied onto a substrate at moderate temperature such that the temperature is high enough to evaporate the solvent but not decompose the chelate with metal chelate decomposition occurring in a subsequent photochemical, or laser treatment.

Unless specifically defined otherwise, all technical or scientific terms used herein have the same meaning as commonly understood by one of ordinary skill in the art to which this invention belongs. Although any methods and materials similar or equivalent to those described herein can be used in the practice or testing of the present invention, the preferred methods and materials are now described.

### Brief Description of the Drawings.

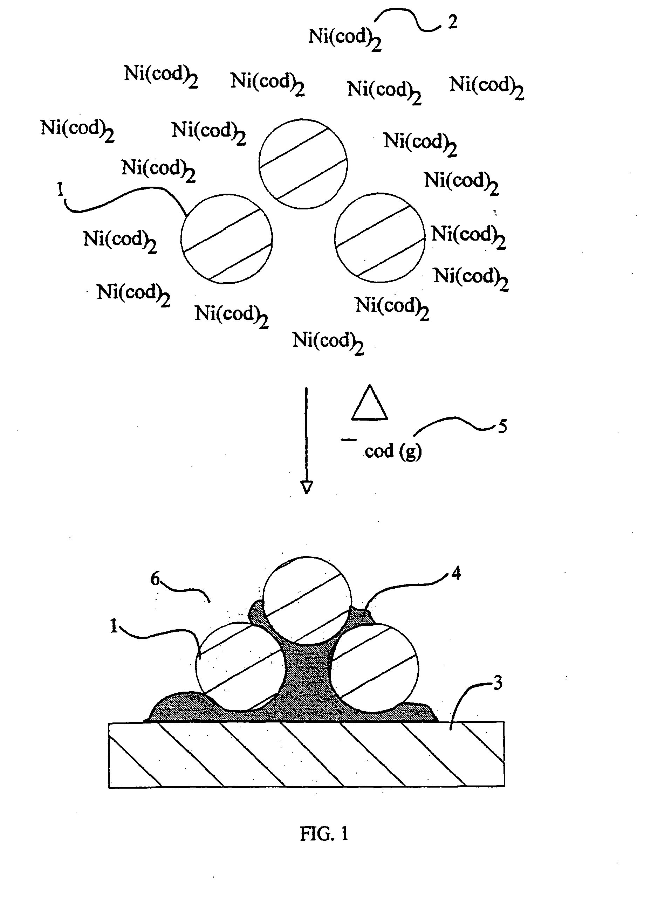

Figure 1, is a schematic of processing steps used to generate a thin-film according to an embodiment of the invention.

### Description of the Preferred Embodiments.

The present invention provides a process for forming thin-films of conductors from particle precursors. One example of a conducting thin-film, according to the present invention, is the formation of a composite nickel contact useful in the fabrication of CIS solar cells. The method provides the formation of electrically conducting particle-derived films whereby a mixture of particles, such as nickel, and metal chelates, such as Ni(cyclooctadiene)₂, are deposited on a substrate and through photolytic decomposition of the metal chelates, a conducting matrix of particles and metallic complex decomposition products is formed. While the example which follows describes in detail the formation of a nickel conducting film, using nickel nanoparticles (less than 10 nm) in a metal chelate complex. as a preferred embodiment of the process of the invention it is specifically within the scope of the invention to use particles larger than 10 nm..

Figure 1 is a general schematic drawing of the processing steps used to generate a nickel conductor film having electrical conductivity and structural connectivity to a ZnO layer in CIS solar cells. In Figure 1, a mixture is prepared comprising Ni particles (-6 nm) (1) and metal-chelate complex (2), in a solvent. Metal-chelate (2) is Ni (cyclooctadiene)₂ (Ni(cod)₂ in the drawing)) in a tetrahydrofuran solvent. The mixture is slurry deposited onto substrate (3), such as the ZnO overlay in a CIS solar cell. The substrate is heated above the boiling point of the solvent and then above the decomposition temperature of the chelate complex (2) whereby chelate complex (2) decomposes to form Ni metallic decomposition products (4) and volatile cyclooctadiene (5). Stable composite conducting assemblage, shown generally as, (6) is thereby formed as an electrically conducting film on substrate (3). Careful control of the annealing ambient is an important factor in the decomposition phase to ensure formation of the desired products. For example, the thermal decomposition of a metal-chelate complex under nitrogen, hydrogen, or non-flammable hydrogen and nitrogen mixture gas (10%H₂ makeup N₂), may result in the metallic product phase while decomposition in air or oxygen could give rise to a metal oxide. The use of metal-chelates that are readily decomposed using photons (that is, photochemical decomposition) provides an alternative route to thermal decomposition.

Polycrystalline photovoltaic cell technology has occasioned the use of many particle-derived film layer systems. These particles include, without limitation, all metals having properties as conductors, such as Ni, Au, Al, Ag, Mo; transparent conductors, such as ZnO, and Sn0₂ often used in contact grid layers; III-V semiconducting compounds such as GaAs, GaP, GaInP₂, GaSb, InAs, InP, InSb, AlAs, AIP, and AlSb; and group II-VI semiconducting compounds such as CdS, CdSe, CdTe, HgTe, ZnS, ZnSe and ZnTe, and also Sb-Te. These compounds and their application in solid state electronic devices are well known, in other than particle form. Moreover, the particle-derived films, according to the invention herein, can be formed on any suitable surface or substrate, for example on glass, carbon, silicon, silica, alumina, boria, titania, or thermally stable polymers such as aramids, carbonates, esters, and the like.

## Claims

1. A process for forming an electrically conducting film on a substrate, comprising, depositing metal particles and metal-chelates, mixed or separately, on a substrate to form a thin film composite, treating the composite sufficient to cause the decomposition of the metal-chelate, and forming an electrically conducting film assemblage wherein decomposition products of the metal chelate form a conductive bond, and wherein treating the composite is by photolytic action.

2. The process for forming an electrically conducting film on a substrate of claim 1, comprising, mixing metal particles and metal-chelates in a solvent, depositing the mixture on a substrate, evaporating the solvent, decomposing the metalchelates and bonding of the metal particles by the metal-chelate decomposition products.

3. The process of claim 1 wherein the metal-chelate is selected from a group consisting of metal carboxylates, metal β-diketonates, metal amides, metal organometallics and metal alkoxides.

4. The process of claim 2 wherein the metal-chelate complex metal is nickel(cyclooctadiene)₂.

## Patentansprüche

1. Ein Verfahren zum Ausbilden eines elektrisch leitenden Films auf einem Substrat, umfassend Abscheiden von Metallteilchen und Metallchelaten, gemischt oder getrennt, auf einem Substrat, um ein Dünnfilmkomposit auszubilden, Behandeln des Komposits in ausreichender Weise, um die Zersetzung des Metallchelats zu verursachen, und Ausbilden einer elektrisch leitenden Film-Menge, wobei Zersetzungsprodukte des Metallchelats eine leitfähige Bindung ausbilden, und wobei Behandeln des Komposits durch photolytische Wirkung erfolgt.

2. Das Verfahren zum Ausbilden eines elektrisch leitenden Films auf einem Substrat nach Anspruch 1, umfassend Mischen von Metallteilchen und Metallchelaten in einem Lösemittel, Abscheiden der Mischung auf einem Substrat, Verdampfen des Lösemittels, Zersetzen der Metallchelate und Binden der Metallteilchen durch die Metallchelat-Zersetzungsprodukte.

3. Das Verfahren nach Anspruch 1, wobei das Metallchelat ausgewählt ist aus einer Gruppe, die aus Metallcarboxylaten, Metall-β-Diketonaten, Metallamiden, Metall-Organometallen und Metallalkoxiden besteht.

4. Das Verfahren nach Anspruch 2, wobei der Metallchelat-Komplex Nickel(cyclooctadien)₂ ist.

## Revendications

1. Procédé pour former un film électro-conducteur sur un substrat, comprenant le dépôt de particules métalliques et de chélates métalliques, ensemble ou séparément, sur un substrat pour former un composite en couches minces, le traitement du composite de manière suffisante pour provoquer la décomposition du chélate métallique, et la formation d'un assemblage à film électro-conducteur dans lequel les produits de décomposition du chélate métallique forment une liaison conductrice, et dans lequel le traitement du composite se fait par voie photolytique.

2. Procédé pour former un film électro-conducteur sur un substrat selon la revendication 1, comprenant le mélange de particules métalliques et de chélates métalliques dans un solvant, le dépôt du mélange sur un substrat, l'évaporation du solvant, la décomposition des chélates métalliques et la liaison des particules métalliques par les produits de décomposition des chélates métalliques.

3. Procédé selon la revendication 1, dans lequel le chélate métallique est choisi dans un groupe constitué des carboxylates métalliques, des β-dicétonates métalliques, des amides métalliques, des composés organométalliques et des alcoxydes métalliques.

4. Procédé selon la revendication 2, dans lequel le complexe chélate métallique est le nickel(cyclooctadiène)₂.
